# EUROPÄISCHE PATENTSCHRIFT

(11) **EP 1 990 328 B1**
(45) Veröffentlichungstag und Bekanntmachung des Hinweises auf die Patenterteilung: **26.10.2011**
(21) Anmeldenummer: 07009114.5
(22) Anmeldetag: 07.05.2007
(51) Int. Cl.: C04B 35/468, C04B 35/50, C23C 28/00, C23C 30/00

(54) **Keramisches Pulver, keramische Schicht sowie Schichtsystem aus zwei Pyrochlorphasen und Oxiden**
Ceramic powder, ceramic layer and layer system with two pyrochlorphases and oxides
Poudre céramique, couche céramique tout comme système de couche comportant deux phrases pyrochlores et des oxydes

(43) Veröffentlichungstag der Anmeldung: 12.11.2008
(60) Teilanmeldung: 10013926.0
(73) Patentinhaber: SIEMENS AKTIENGESELLSCHAFT, 80333 München (DE)
(72) Erfinder: Subramanian, Ramesh, Dr., 10777 Berlin (DE)

(56) Entgegenhaltungen:
- EP-A- 1 790 754
- EP-A- 1 806 432
- EP-A- 1 806 435
- US-A1- 2004 106 015

## Beschreibung

Die Erfindung betrifft ein keramisches Pulver, eine keramische Schicht sowie ein Schichtsystem aus zwei Pyrochlorphasen und Oxiden gemäß Anspruch 1, 20, 22.

Ein solches Schichtsystem weist ein Substrat mit einer Metalllegierung auf der Basis von Nickel oder Kobalt auf. Derartige Erzeugnisse dienen vor allem als Bauteil einer Gasturbine, insbesondere als Gasturbinenschaufeln oder Hitzeschilde. Die Bauteile sind einem Heißgasstrom von aggressiven Verbrennungsgasen ausgesetzt. Daher müssen sie hohen thermischen Belastungen Stand halten können. Des Weiteren ist es erforderlich, dass diese Bauteile oxidations- und korrosionsbeständig sind. Vor allem an bewegliche Bauteile, z. B. Gasturbinenschaufeln, aber auch an statische Bauteile sind fernerhin mechanische Anforderungen zu stellen. Die Leistung und der Wirkungsgrad einer Gasturbine, in der heißgasbelastbare Bauteile Verwendung finden, steigen mit zunehmender Betriebstemperatur. Daher wurde immer wieder versucht, durch Verbesserung des Beschichtungssystems eine höhere Leistungsfähigkeit von Gasturbinen zu erzielen.

Um einen hohen Wirkungsgrad und eine hohe Leistung zu erzielen, werden durch die hohen Temperaturen besonders belastete Komponenten der Gasturbinen mit einem keramischen Werkstoff beschichtet. Dieser wirkt als Wärmedämmschicht zwischen dem Heißgasstrom und dem metallischen Substrat.

Vor dem aggressiven Heißgasstrom wird der metallische Grundkörper durch Beschichtungen geschützt. Dabei weisen moderne Bauteile zumeist mehrere Beschichtungen auf, die jeweils spezifische Aufgaben erfüllen. Es liegt somit ein Mehrschichtsystem vor.

Die EP 0 944 746 B1 offenbart die Verwendung von Pyrochloren als Wärmedämmschicht.

Jedoch sind für den Einsatz eines Materials als Wärmedämmschicht nicht nur gute wärmedämmende Eigenschaften notwendig, sondern auch eine gute Anbindung an das Substrat.

Die EP 0 992 603 A1 offenbart ein Wärmedämmschichtsystem aus Gadoliniumoxid und Zirkonoxid, das keine Pyrochlorstruktur aufweisen soll.

Die US 2004/0106015 A1 offenbart eine Mischung aus ZrO₂, einer Pyrochlorphase, einer Magnetoplumbitphase
und weiteren Additiven Es ist daher Aufgabe der Erfindung, ein keramisches Pulver, eine keramische Schicht sowie ein Schichtsystem aufzuzeigen, das gute wärmedämmende Eigenschaften sowie eine gute Anbindung an das Substrat und damit eine lange Lebensdauer des gesamten Schichtsystems aufweist.

Die Aufgabe wird gelöst durch ein keramisches Pulver gemäß Anspruch 1, eine keramische Schicht nach Anspruch 20 sowie ein Schichtsystem nach Anspruch 22.

In den Unteransprüchen sind weitere vorteilhafte Maßnahmen aufgeführt, die beliebig in vorteilhafter Art und Weise miteinander kombiniert werden können.

Der Erfindung liegt die Erkenntnis zugrunde, dass das gesamte System als Einheit betrachtet werden muss und nicht einzelne Schichten oder einzelne Schichten untereinander isoliert von einander betrachtet und optimiert werden dürfen, um eine lange Lebensdauer zu erzielen.

Das erfindungsgemäße keramische Pulver sowie das Schichtsystem weisen eine äußere keramische Schicht auf, die eine Mischung aus zwei Pyrochlorphasen aufweist, die besonders gute thermische Eigenschaften (an ein Substrat eines Bauteils angepasster Ausdehnungskoeffizient, geringer Wärmeleitkoeffizient) aufweist und sehr gut harmoniert mit einer Zwischenschicht und dem Substrat des Bauteils. Durch das Mischungsverhältnis dieser zwei Pyrochlorphasen können die Eigenschaften der keramischen Schicht an das Substrat und die Zwischenschicht eingestellt werden.

Ausführungsbeispiele der Erfindung werden nachfolgend unter Bezugnahme auf die Zeichnungen noch näher erläutert.

Es zeigen
- Figur 1: ein erfindungsgemäßes Schichtsystem, Figur 2 eine Auflistung von Superlegierungen,
- Figur 3: eine Gasturbine,
- Figur 4: perspektivisch eine Turbinenschaufel,
- Figur 5: perspektivisch eine Brennkammer.

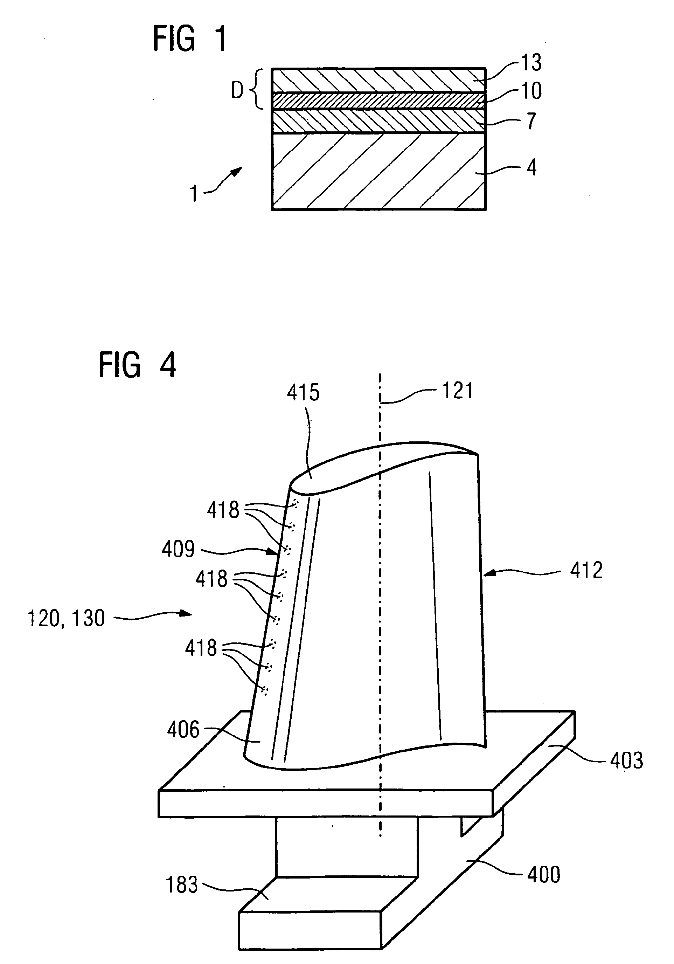

Die Zusammensetzung des keramischen Pulver kann auch anhand der Zusammensetzung der keramischen Schicht 13 (Fig. 1) erläutert sein.

Das keramische Pulver weist erfindungsgemäß zwei Pyrochlorphasen der allgemeinen Summenformel AₓByO_{z} auf mit x, y ≈ 2, z ≈ 7, d.h. geringe Fehlstellen oder Dotierungen sind zulässig, O = Sauerstoff.

Beispiele für A sind Gadolinium (Gd), Lanthan (La), Yttrium (Y), Neodym (Nd), Ytterbium (Yb), Cer (Ce) oder Aluminium (Al).

B ist Hafnium (Hf) and B'ist Zirkon (Zr).

Insbesondere gilt x, y = 2, z = 7.

Die keramische Schicht weist also ein erstes Pyrochlor AₓB_{y}O_{z} und ein zweites Pyrochlor A'ₓ,B'_{y'}O_{z'} mit x', y' ≈ 2, z' ≈7, O = Sauerstoff, auf. Insbesondere gilt x', y' = 2, z' = 7. Vorzugsweise wird Gadolinium (Gd) für A und/oder A' verwendet.

wird ein Hafnat oder ein Zirkonat verwendet, also Hafnium und/oder Zirkon für B, vorzugsweise Gadoliniumoxid (GHO), vorzugsweise Gd₂Hf₂O₇, und/oder Gadoliniumzirkonat (GZO) , vorzugsweise Gd₂Zr₂O₇.

Das keramische Pulver oder die äußere keramische Schicht 13 weist nur zwei Pyrochlorphasen auf. Vorzugsweise wird Gadoliniumhafnat, vorzugsweise Gd₂Hf₂O₇, und Gadoliniumzirkonat, vorzugsweise Gd₂Zr₂O₇, verwendet.

Dabei liegt vorzugsweise kein Mischkristall der zwei Pyrochlorphasen vor, also bspw. nicht Gdₓ(Hf_{y}Zr_{w})O_{z} mit x = 2, y+w = 2, z = 7 (ein Mischkristall weist auch die Pyrochlorphase auf; wenn nicht explizit von einem Mischkristall gesprochen wird, liegt auch keiner vor).

Der Anteil der Mischkristalle Aₓ(B_{y}B'_{w})O_{z}, A' (B'ₜB_{q}) O oder der Oxide von A, B, A', B' (also bspw. Gd, Hf, Zr) liegt bei maximal 10wt%.

Vorzugsweise liegt der Anteil der zwei Pyrochlorphasen in dem Pulver oder in der keramischen Schicht bei mindestens 90wt%.

Ebenso weist das eine Pyrochlorpulver mit der allgemeinen Formel A₂B₂O₇ ein Sekundäroxid, insbesondere ein Oxid des Elements B', auf (bzw. A'₂B'₂O₇ weist als Oxid B auf). Das Sekundäroxid von B und/oder B' kann vorzugsweise als reines Oxid im dem Pulver vorliegen oder vorzugsweise mit dem einen Pyrochlorpulver nur zum Teil eine Mischkristallphase bilden.

Das Sekundäroxid wird bewusst zu dem Pulver hinzugefügt, liegt also deutlich über der messtechnischen Nachweisgrenze des Sekundäroxids, also weist mindestens den doppelten Wert der Nachweisgrenze des Sekundäroxids auf.

So weist vorzugsweise das Gadoliniumzirkonatpulver Hafniumoxid auf mit einem Anteil von 0,1wt% bis 2,5wt%.

Ebenso vorzugsweise weist das andere Pyrochlorpulver, vorzugsweise Gadoliniumhafnat, ein Sekundäroxid von Zirkon auf. Das Zirkonoxid kann vorzugsweise als reines Oxid vorliegen oder vorzugsweise nur teilweise auch als Mischkristall. Dabei weist das Zirkonoxid Anteile von 0,1wt% bis 7wt% auf.

Die beiden Pyrochlorphasen weisen noch weitere Bestandteile wie 0,05wt% Siliziumoxid, 0,1wt% Kalziumoxid, 0,1wt % Magnesiumoxid, 0,1wt% Eisenoxid, 0,1wt% Aluminiumoxid und 0,08wt% Titanoxid auf, die als Sinterhilfen die Bildung einer dichteren Schicht fördern.

Gadoliniumhafnat weist als Pulver 43wt% bis 50wt%, vorzugsweise 44,7wt% bis 47,7wt% Gadoliniumoxid und Rest Hafniumoxid und optional die Sekundäroxide, vorzugsweise Zirkonoxid (bis 7wt%), und optional die Sinterhilfen auf.

Gadoliniumzirkonat weist als Pulver 56wt% bis 63wt%, vorzugsweise 58wt% bis 61wt% Gadoliniumoxid und Rest Zirkonoxid und optional die Sekundäroxide, vorzugsweise Hafniumoxid (bis 2wt%), und optional Sinterhilfen auf.

Bei der Pulvermischung sind diese Anteile der Oxide von Gd, Zr, Hf entsprechend dem Verhältnis von Hf und Zr in den Pyrochlorphasen vorhanden.

Figur 1 zeigt ein erfindungsgemäßes Schichtsystem 1.

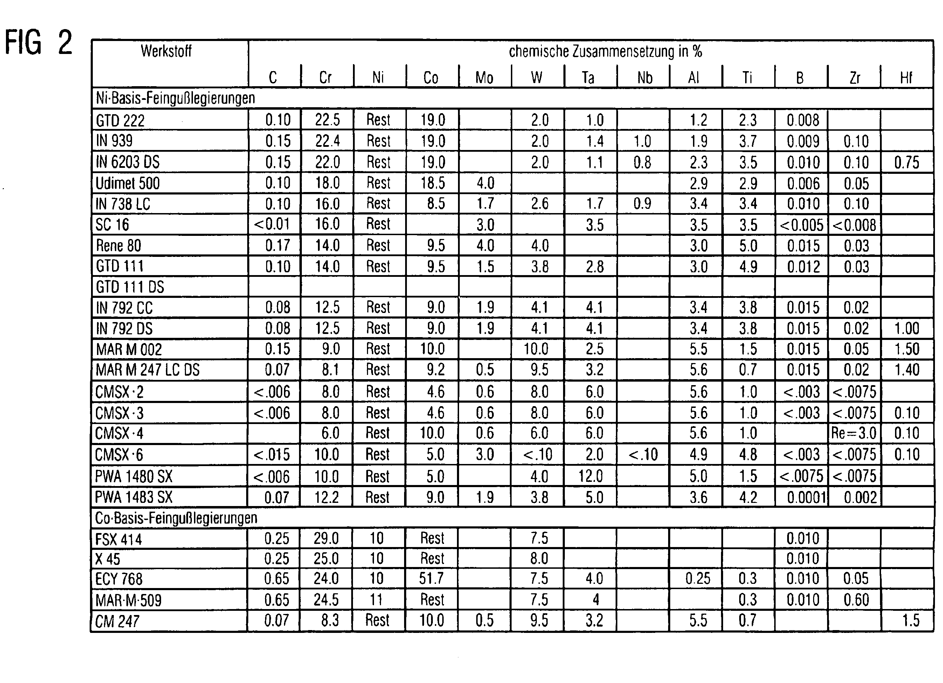

Das Schichtsystem 1 weist ein metallisches Substrat 4, das insbesondere für Bauteile bei hohen Temperaturen aus einer nickel- oder kobaltbasierten Superlegierung (Fig. 2) besteht, auf.

Vorzugsweise direkt auf dem Substrat 4 ist vorzugsweise eine metallische Anbindungsschicht 7 MCrAIX, vorzugsweise des Typs NiCoCrALX vorhanden, die vorzugsweise entweder (11 - 13)wt% Kobalt, (20 - 22)wt% Chrom, (10,5 - 11,5)wt% Aluminium, (0,3 - 0,5)wt% Yttrium, (1,5 - 2,5)wt% Rhenium und Rest Nickel oder vorzugsweise (24 - 26)wt% Kobalt, (16 - 18)wt% Chrom, (9,5 - 11)wt% Aluminium, (0,3 - 0,5)wt% Yttrium, (1 - 1,8)wt% Rhenium und Rest Nickel aufweist.

Vorzugsweise besteht die Schutzschicht 7 aus einer dieser beiden Legierungen.

Auf dieser metallischen Anbindungsschicht 7 ist bereits vor dem Aufbringen weiterer keramischer Schichten eine Aluminiumoxidschicht entstanden oder während des Betriebs entsteht eine solche Aluminiumoxidschicht (TGO).

Auf der metallischen Anbindungsschicht 7 oder auf der Aluminiumoxidschicht (nicht dargestellt) ist vorzugsweise eine innere keramische Schicht 10, vorzugsweise eine vollständig oder teilweise stabilisierte Zirkonoxidschicht vorhanden. Vorzugsweise wird Yttrium-stabilisiertes Zirkonoxid (YSZ) verwendet, das vorzugsweise 6wt% bis 8wt% Yttrium enthält. Ebenso kann Kalziumoxid, Ceroxid oder Hafniumoxid zur Stabilisierung von Zirkonoxid verwendet werden.

Das Zirkonoxid wird vorzugsweise als plasmagespritzte Schicht aufgetragen, kann aber vorzugsweise auch als kolumnare Struktur mittels Elektronenstrahlverdampfen (EBPVD) aufgebracht werden.

Auf der Zirkonoxidschicht 10, auf der metallischen Anbindungsschicht 7 oder auf dem Substrat 4 ist dann eine äußere keramische Schicht 13 aufgebracht.

Vorzugsweise ist die Schicht 13 die äußerste Schicht.

Die äußere keramische Schicht 13 wird daher beispielsweise wie folgt hergestellt: Es wird ein Pulver, bestehend aus zwei Pyrochlorphasen, bspw. Gadoliniumzirkonat und ein Pulver aus Gadoliniumhafnat, im Mischungsverhältnis miteinander vermischt und der Düse einer Plasmaspritzanlage zugeführt. Andere Beschichtungsverfahren, wie z.B. PVD-Verfahren, bei denen zwei Ingots, bestehend aus Gadoliniumzirkonat und Gadoliniumhafnat, verwendet werden, sind ebenfalls denkbar.

Das Schichtsystem 1 besteht vorzugsweise aus dem Substrat 4, einer Anbindungsschicht 7 (MCrAIX), ggf. einer TGO und einer äußeren einlagigen (bspw. GZO und/oder GHO) oder zweilagigen Wärmedämmschicht 13 (YSZ und GZO bzw. GHO).

Das Sekundäroxid oder die Sekundäroxide sind in der Schicht 13 verteilt, insbesondere homogen verteilt.

Vorzugsweise wird ein größerer Anteil von Gadoliniumzirkonat verwendet. Ebenso werden Vorzugsweise von 10:90, 20:80, 30:70 oder 40:60 für Gadoliniumhafnat zu Gadoliniumzirkonat verwendet. Weiterhin vorteilhaft ist es, Mischungsverhältnisse von 50:50, 60:40, 70:30, 80:20 oder 90:10 für Gadoliniumhafnat zu Gadoliniumzirkonat zu verwenden.

Die Schichtdicke der inneren Schicht 10 beträgt vorzugsweise zwischen 10% und 50% der Gesamtschichtdicke D von innerer Schicht 10 und äußerer Schicht 13 (Fig. 1).

Vorzugsweise liegt die Schichtdicke der inneren Schicht 10 zwischen 10% und 40% oder zwischen 10% und 30% der Gesamtschichtdicke D.

Ebenso vorteilhaft ist es, wenn die Schichtdicke der inneren Schicht 10 10% bis 20% der Gesamtschichtdicke D aufweist. Ebenso vorzugsweise ist es, wenn die Schichtdicke der inneren Schicht 10 zwischen 20% und 50% oder zwischen 20% und 40% der Gesamtschichtdicke D beträgt.

Wenn der Anteil der inneren Schicht 10 an der Gesamtschichtdicke D zwischen 20% und 30% liegt, werden ebenso vorteilhafte Ergebnisse erzielt.

Vorzugsweise beträgt die Schichtdicke der inneren Schicht 10 30% bis 50% der Gesamtschichtdicke D.

Ebenso vorteilhaft ist es, wenn die Schichtdicke der inneren Schicht 10 30% bis 40% der Gesamtschichtdicke D aufweist. Ebenso vorzugsweise ist es, wenn die Schichtdicke der inneren Schicht 10 zwischen 40% und 50% der Gesamtschichtdicke D beträgt.

Die innere keramische Schicht 10 hat vorzugsweise eine Dicke von 100µm bis 200µm, insbesondere 150µm ± 10 %.

Die Gesamtschichtdicke D von der inneren Schicht 10 und der äußeren Schicht 13 beträgt vorzugsweise 300µm oder vorzugsweise 450 µm. Die maximale Gesamtschichtdicke beträgt vorteilhafterweise 800µm oder vorzugsweise maximal 600µm.

Für den Kurzzeiteinsatz bei hohen Temperaturen des Schichtsystems kann die äußere Schicht 13 dünner als die innere Schicht 10 ausgeführt sein, also beträgt die Schichtdicke der äußeren Schicht 13 zwischen 10% und 40% der Gesamtschichtdicke aus innerer Schicht 10 und äußerer Schicht 13.

Vorzugsweise wird ein Gemisch aus Gd₂Hf₂O₇ und Gd₂Zr₂O₇ verwendet, die vorzugsweise gleichmäßig miteinander vermischt sind oder einen Gradienten aufweisen. Also beispielsweise ist außen hin zur Heißgasseite ein höherer Anteil von Gd₂Zr₂O₇ vorhanden.

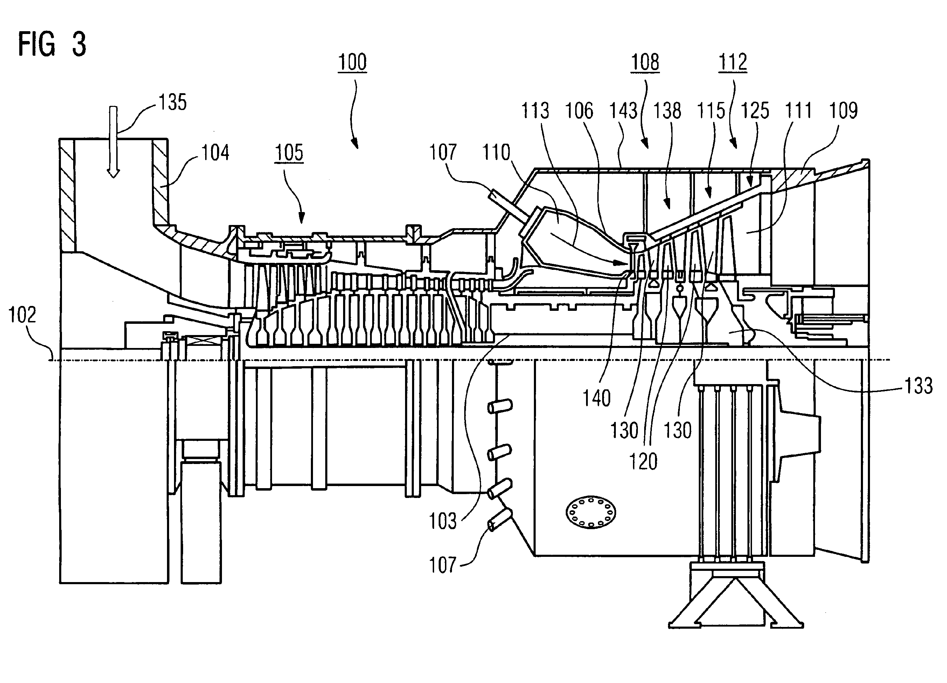

Die Figur 3 zeigt beispielhaft eine Gasturbine 100 in einem Längsteilschnitt.

Die Gasturbine 100 weist im Inneren einen um eine Rotationsachse 102 drehgelagerten Rotor 103 mit einer Welle 101 auf, der auch als Turbinenläufer bezeichnet wird.

Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 Al, WO 99/67435 oder WO 00/44949 bekannt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/-67435 oder WO 00/44949 bekannt.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).

Solche Verfahren sind aus der US-PS 6,024,792 und der EP 0 892 090 A1 bekannt.

Ebenso können die Schaufeln 120, 130 erfindungsgemäße Schichtsysteme 1 darstellen oder andere Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Auf der MCrAlX ist noch eine Wärmedämmschicht 13 des erfindungsgemäßen Schichtsystems 1 vorhanden.

Die Wärmedämmschicht 13 bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAIX-Schicht.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

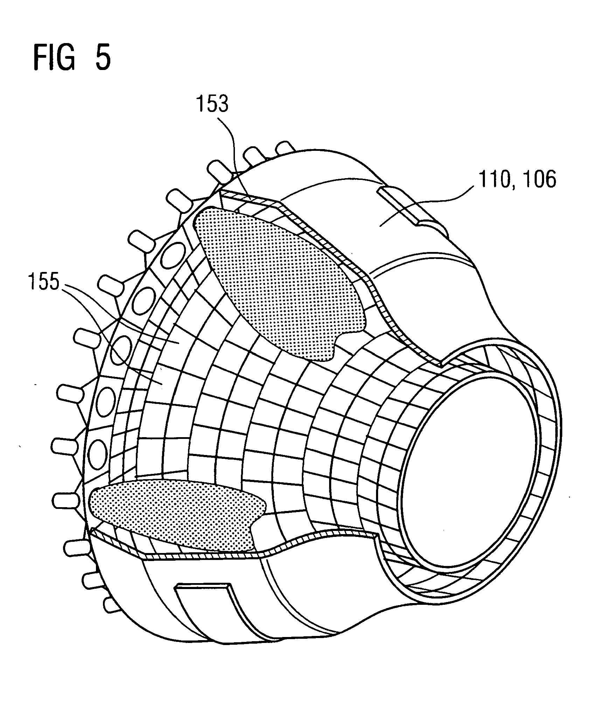

Die Figur 5 zeigt eine Brennkammer 110 der Gasturbine 100. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

Jedes Hitzeschildelement 155 aus einer Legierung ist arbeitsmediumsseitig mit einer besonders hitzebeständigen Schutzschicht (MCrA1X-Schicht und/oder keramische Beschichtung) ausgestattet, also stellt das erfindungsgemäße Schichtsystem 1 dar, oder ist aus hochtemperaturbeständigem Material (massive keramische Steine) gefertigt.

Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1.

Auf der MCrAlX kann noch eine erfindungsgemäße keramische Wärmedämmschicht 13 vorhanden sein.

Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Turbinenschaufeln 120, 130, Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in der Turbinenschaufel 120, 130 oder dem Hitzeschildelement 155 repariert. Danach erfolgt eine Wiederbeschichtung der Turbinenschaufeln 120, 130, Hitzeschildelemente 155 und ein erneuter Einsatz der Turbinenschaufeln 120, 130 oder der Hitzeschildelemente 155.

## Patentansprüche

1. Keramisches Pulver,
bestehend aus
einem Gemisch aus
einer ersten Pyrochlorphase AₓB_{y}O_{z} mit x, y ≈ 2, z ≈ 7 und
einer zweiten Pyrochlorphase A'_{x'}B'_{y}.O_{z}. mit x', y' ≈ 2, z'
≈ 7,
mit mindestens einem und bis zu zwei Sekundäroxiden von B
oder B',
mit einem Anteil von 0.1wt% bis 10wt% Gelöscht:
sowie
Siliziumoxid und/oder Kalziumoxid und/oder Magnesiumoxid,
Eisenoxid und/oder Aluminiumoxid und/oder Titanoxid
besteht, mit
0,05wt% Siliziumoxid,
0,1wt% Kalziumoxid,
0,1wt% Magnesiumoxid,
0,1wt% Eisenoxid,
0,1wt% Aluminiumoxid und
0,08wt% Titanoxid,
bei dem die erste Pyrochlorphase ein Hafnat (B = Hf) ist,
bei dem die zweite Pyrochlorphase ein Zirkonat (B' = Zr)
ist;
bei dem das Mischungsverhältnis von erster und zweiter Pyrochlorphase zwischen 30:70 und 20:80 beträgt.
bei dem das Mischungsverhältnis von erster und zweiter pyrochlorphase zwischen 50:50 und 40:60 beträgt.
bei dem das Mischungsverhältnis von erster und zweiter Pyrochlorphase zwischen 70:30 und 60:40 beträgt
bei dem das Mischungsverhältnis von erster und zweiter pyrochlorphase zwischen 90:10 und 80:20 beträgt

2. Keramisches Pulver nach Anspruch 1,
bei dem A Gadolinium (Gd) ist.

3. Keramisches Pulver nach Anspruch 1,
bei dem Gadolinium (Gd) für die erste und die zweite Pyrochlorphase verwendet wird (A = Gd, A' = Gd).

4. Keramisches pulver nach Anspruch 1,
bei dem die erste Pyrochlorphase Gadoliniumhafnat,
insbesondere (Gd₂Hf₂O₇),

5. Keramisches Pulver nach Anspruch 1 oder 4,
bei dem die zweite Pyrochlorphase Gadoliniumzirkonat,
insbesondere (Gd₂Zr₂O₇),
ist.

6. Keramisches Pulver nach Anspruch 1, 2, 3, 4, oder 5,
bei dem entweder von B oder B' ein Sekundäroxid vorhanden
ist.

7. Keramisches Pulver nach Anspruch 1, 2, 3, 4, oder 5,
bei dem Sekundäroxide von B und B' vorhanden sind.

8. Keramisches Pulver nach Anspruch 1,
das aus zwei Pyrochlorphasen und zwei Sekundäroxiden und
optional Sinterhilfen besteht.

9. Keramisches Pulver nach Anspruch 1, 6, 7, oder 8,
bei dem 0,1wt% bis 2,5wt% des Sekundäroxids,
insbesondere 1,25wt% Sekundäroxid vorhanden ist.

10. Keramisches Pulver nach Anspruch 1, 5, oder 9,
das Hafniumoxid aufweist. Gelöscht: 11

11. Keramisches Pulver nach Anspruch 1, 6, 7, oder 8,
bei dem 0,1wt% bis 7wt% des Sekundäroxids,
insbesondere 3wt% Sekundäroxid vorhanden ist.

12. Keramisches Pulver nach Anspruch 1, 4,oder 11, das als Sekundäroxid Zirkonoxid aufweist.

13. Keramisches Pulver nach Anspruch 1, 4, 5, oder 8 bis 12,
bei dem nur Sekundaroxlde von B und B' vorhanden sind.

14. Keramisches Pulver nach einem der Ansprüche 1 oder 6 bis 13,
bei dem die Sekundäroxide von B, B' kein Mischkristall mit einer der beiden Pyrochlorphasen bilden.

15. Keramisches Pulver nach einem der Anspruche 1 oder 6 bis 13,
bei dem die Sekundäroxide von B, B' nur als Mischkristall vorliegen.

16. Keramisches Pulver nach einem der Ansprüche 6 bis 13,
bei dem die Sekundäroxide von B, B' als Oxid und als Mischkristall vorliegen.

17. Keramisches Pulver nach Anspruch 1,
bei dem das keramische Pulver maximal 10wt%, insbesondere maximal 7wt% eines Mischkristalls aufweist.

18. Keramisches Pulver nach Anspruch 1,
bei dem die erste und zweite Pyrochlorphase kein Mischkristall bilden.

19. Keramisches Pulver nach Anspruch 1, bei dem x, y = 2 und z = 7 ist.

20. Keramische Schicht (13),
hergestellt aus einem keramischen Pulver nach einem oder
mehreren der vorherigen Ansprüche 1 bis 19,

21. Keramische Schicht (13),
hergestellt ausschließlich aus einem keramischen Pulver
nach einem oder mehreren der vorherigen Ansprüche 1 bis 19.

22. Schichtsystems,
aufweisend eine keramische Schicht (13) nach Anspruch 20 oder 21.

23. Schichtsystems nach Anspruch 22,
bei dem unter der keramischen Schicht (13) eine innere
keramische Schicht (10),
insbesondere eine stabilisierte Zirkonoxidschicht,
insbesondere eine mit 6wt% - 8wt% Yttrium-stabilisierte
Zirkonoxidschicht vorhanden ist.

24. Schichtsystem nach Anspruch 23,
bei dem die innere Schicht (10) eine Schichtdicke zwischen 10% und 50% der Gesamtschichtdicke (D) der inneren keramischen Schicht (10) und der äußeren keramischen Schicht (13) aufweist,
insbesondere zwischen 10% und 40% der Gesamtschichtdicke (D).

25. Schichtsystem nach Anspruch 23 oder 24,
bei dem die Schichtdicke der inneren Schicht (10) und der
äußeren Schicht (13) zusammen mindestens 300µm beträgt,
insbesondere 300 µm beträgt.

26. Schichtsystem nach Anspruch 23 oder 24,
bei dem die Schichtdicke der inneren Schicht (10) und der äußeren Schicht (13) zusammen mindestens 450µm beträgt,
insbesondere 450µm beträgt.

27. Schichtsystem nach Anspruch 23,
bei dem die innere Schicht (10) eine Schichtdicke von 60% bis 90% der Gesamtschichtdicke (D) aufweist.

28. Schichtsystem nach Anspruch 22, 23, 24, 25, 26 oder 27,
bei dem die keramische Schicht (13) die äußerste Schicht darstellt.

29. Schichtsystem nach Anspruch 22 oder 27,
bei dem das Schichtsystem (1) eine metallische Anbindungsschicht (7),
insbesondere aus einer NiCoCrAlX-Legierung,
auf dem Substrat (4) und unter den keramischen Schichten (10, 13) aufweist.

30. Schichtsystem nach Anspruch 29, bei dem die metallische Anbindungsschicht (7) die Zusammensetzung (in wt%)
11% - 13% Kobalt,
20% - 22% Chrom,
10,5% - 11,5% Aluminium,
0,3% - 0,5% Yttrium,
1,5% - 2,5% Rhenium und
Rest Nickel,
aufweist,
insbesondere daraus besteht.

31. Schichtsystem nach Anspruch 29, bei dem die metallische Anbindungsschicht (7) die Zusammensetzung (in wt%)
24% - 26% Kobalt,
16% - 18% Chrom,
9,5% - 11% Aluminium,
0,3% - 0,5% Yttrium,
1% - 1,8% Rhenium und
Rest Nickel,
aufweist,
insbesondere daraus besteht.

## Claims

1. Ceramic powder,
consisting of
a mixture of a first pyrochlore phase A_{X}B_{y}O_{z} with x, y ≈ 2, z ≈ 7 and
a second pyrochlore phase A'_{x'}B'_{y'}O'_{z'} with x', y' ≈ 2, z' ≈ 7,
with at least one and up to two secondary oxides of B or B',
with a proportion of from 0.1 wt% to 10 wt%, and
silicon oxide and/or calcium oxide and/or magnesium oxide, iron oxide and/or aluminium oxide and/or titanium oxide, having
0.05 wt% silicon oxide,
0.1 wt% calcium oxide,
0.1 wt% magnesium oxide,
0.1 wt% iron oxide,
0.1 wt% aluminium oxide and
0.08 wt% titanium oxide,
wherein the first pyrochlore phase is a hafnate (B = Hf), wherein the second pyrochlore phase is a zirconate (B' = Zr);
wherein the mixing ratio of the first and second pyrochlore phases is between 30:70 and 20:80, or
wherein the mixing ratio of the first and second pyrochlore phases is between 50:50 and 40:60, or
wherein the mixing ratio of the first and second pyrochlore phases is between 70:30 and 60:40, or wherein the mixing ratio of the first and second pyrochlore phases is between 90:10 and 80:20.

2. Ceramic powder according to Claim 1,
wherein A is gadolinium (Gd).

3. Ceramic powder according to Claim 1,
wherein gadolinium (Gd) is used for the first and second pyrochlore phases (A = Gd, A' = Gd).

4. Ceramic powder according to Claim 1,
wherein the first pyrochlore phase is gadolinium hafnate, in particular (Gd₂Hf₂O₇) .

5. Ceramic powder according to Claim 1 or 4,
wherein the first pyrochlore phase is gadolinium zirconate, in particular (Gd₂Zr₂O₇) .

6. Ceramic powder according to Claim 1, 2, 3, 4 or 5,
wherein there is a secondary oxide of either B or B'.

7. Ceramic powder according to Claim 1, 2, 3, 4 or 5,
wherein there are secondary oxides of B or B'.

8. Ceramic powder according to Claim 1,
which consists of two pyrochlore phases and two secondary oxides and optionally sintering aids.

9. Ceramic powder according to Claim 1 or 8,
wherein there is from 0.1 wt% to 2.5 wt% of the secondary oxide,
in particular 1.25 wt% of secondary oxide.

10. Ceramic powder according to Claim 1, 5 or 9,
which comprises hafnium oxide.

11. Ceramic powder according to Claim 1, 6, 7 or 8,
wherein there is from 0.1 wt% to 7 wt% of the secondary oxide,
in particular 3 wt% of secondary oxide.

12. Ceramic powder according to Claim 1, 4 or 11,
which comprises zirconium oxide as the secondary oxide.

13. Ceramic powder according to Claim 1, 4, 5 or 8 to 12,
wherein there are only secondary oxides of B and B'.

14. Ceramic powder according to one of Claims 1 and 6 to 13, wherein the secondary oxides of B, B' do not form a mixed crystal with one of the two pyrochlore phases.

15. Ceramic powder according to one of Claims 1 and 6 to 13, wherein the secondary oxides of B, B' are present only as a mixed crystal.

16. Ceramic powder according to one of Claims 6 to 13,
wherein the secondary oxides of B, B' are present as an oxide and as a mixed crystal.

17. Ceramic powder according to Claim 1,
wherein the ceramic powder comprises at most 10 wt%, in particular at most 7 wt% of a mixed crystal.

18. Ceramic powder according to Claim 1,
wherein the first and second pyrochlore phases do not form a mixed crystal.

19. Ceramic powder according to Claim 1,
wherein x, y = 2 and z = 7.

20. Ceramic layer (13),
produced from a ceramic powder according to one or more of the preceding Claims 1 to 19.

21. Ceramic layer (13),
produced exclusively from a ceramic powder according to one or more of the preceding Claims 1 to 19.

22. Layer system,
comprising a ceramic layer (13) according to Claim 20 or 21.

23. Layer system according to Claim 22,
wherein below the ceramic layer (13) there is an inner ceramic layer (10),
in particular a stabilized zirconium oxide layer,
in particular a zirconium oxide layer stabilized with 6 wit% - 8 wt% of yttrium.

24. Layer system according to Claim 23,
wherein the inner layer (10) has a layer thickness of between 10% and 50% of the total layer thickness (D) of the inner ceramic layer (10) plus the outer ceramic layer (13),
in particular between 10% and 40% of the total layer thickness (D).

25. Layer system according to Claim 23 or 24,
wherein the layer thickness of the inner layer (10) plus the outer ceramic layer (13) are together at least 300 µm, in particular 300 µm.

26. Layer system according to Claim 23 or 24,
wherein the layer thickness of the inner layer (10) plus the outer ceramic layer (13) are together at least 450 µm, in particular 450 µm.

27. Layer system according to Claim 23,
wherein the inner layer (10) has a layer thickness equal to from 60% to 90% of the total layer thickness (D).

28. Layer system according to Claim 22, 23, 24, 25, 26 or 27, wherein the ceramic layer (13) constitutes the outermost layer.

29. Layer system according to Claim 22 or 27,
wherein the layer system (1) comprises a metallic bonding layer (7),
in particular of an NiCoCrAlX alloy,
on the substrate (4) and below the ceramic layers (10, 13).

30. Layer system according to Claim 29,
wherein the metallic bonding layer (7) has the composition (in wt%)
11% - 13% cobalt,
20% - 22% chromium,
10.5% - 11.5% aluminium,
0.3% - 0.5 % yttrium,
1.5% - 2.5% rhenium and
the remainder nickel,
and in particular consists thereof.

31. Layer system according to Claim 29,
wherein the metallic bonding layer (7) has the composition (in wt%)
24% - 26% cobalt,
16% - 18% chromium,
9.5% - 11% aluminium,
0.3% - 0.5 % yttrium,
1% - 1.8% rhenium and
the remainder nickel,
and in particular consists thereof.

## Revendications

1. Poudre de céramique,
constituée de
un mélange composé
d'une première phase AₓB_{y}O_{z} pyrochlore avec x, y ≈ 2, z ≈ 7 et
d'une deuxième phase A'_{x'}B'_{y'}O_{z'} pyrochlore avec x', y' ≈ 2, z' ≈ 7,
comprenant au moins un et jusqu'à deux oxydes secondaires de B ou B',
en une proportion de 0,1% en poids jusqu'à 10% en poids, ainsi que
de l'oxyde de silicium et/ou de l'oxyde de calcium et/ou de l'oxyde de magnésium, et/ou de l'oxyde de fer et/ou de l'oxyde d'aluminium et/ou de l'oxyde de titane, en ayant 0,05% en poids d'oxyde de silicium,
0,1% en poids d'oxyde de calcium,
0,1% en poids d'oxyde de magnésium,
0,1% en poids d'oxyde de fer,
0,1% en poids d'oxyde d'aluminium et
0,08% en poids d'oxyde de titane,
dans laquelle la première phase pyrochlore est un hafnate ( B = Hf ),
dans laquelle la deuxième phase pyrochlore est un zirconate ( B' = Zr ),
dans laquelle le rapport de mélange de la première et de la deuxième phases pyrochlores est compris entre 30:70 et 20:80 ou le rapport de mélange de la première et de la deuxième phases pyrochlores est compris entre 50:50 et 40:60 ou le rapport de mélange de la première et de la deuxième phases pyrochlores est compris entre 70:30 et 60:40 ou le rapport de mélange de la première et de la deuxième phases pyrochlores est compris entre 90:10 et 80:20.

2. Poudre de céramique suivant la revendication 1,
dans laquelle A est le gadolinium ( Gd ).

3. Poudre de céramique suivant la revendication 1,
dans laquelle on utilise du gadolinium ( Gd ) pour la première et la deuxième phases pyrochlores ( A = Gd, A' = Gd ) .

4. Poudre de céramique suivant la revendication 1,
dans laquelle la première phase pyrochlore est de l'hafnate de gadolinium, notamment ( Gd₂Hf₂O₇ ).

5. Poudre de céramique suivant la revendication 1 ou 4,
dans laquelle la deuxième phase pyrochlore est du zirconate de gadolinium, notamment ( Gd₂Zr₂O₇ ).

6. Poudre de céramique suivant la revendication 1, 2, 3, 4 ou 5, dans laquelle il y a un oxyde secondaire de B ou de B'.

7. Poudre de céramique suivant la revendication 1, 2, 3, 4 ou 5, dans laquelle il y a des oxydes secondaires de B et de B'.

8. Poudre de céramique suivant la revendication 1,
qui est constituée de deux phases pyrochlores et de deux oxydes secondaires et éventuellement d'adjuvants de frittage.

9. Poudre de céramique suivant la revendication 1, 6, 7 ou 8, dans laquelle il y a de 0,1% en poids jusqu'à 2,5% en poids de l'oxyde secondaire, notamment 1,25% en poids de l'oxyde secondaire.

10. Poudre de céramique suivant la revendication 1, 5 ou 9,
qui comporte de l'oxyde d'hafnium.

11. Poudre de céramique suivant la revendication 1, 6, 7 ou 8,
dans laquelle il y a de 0,1% en poids jusqu'à 7% en poids de l'oxyde secondaire, notamment 3% en poids de l'oxyde secondaire.

12. Poudre de céramique suivant la revendication 1, 4 ou 11,
qui comporte de l'oxyde de zirconium comme oxyde secondaire.

13. Poudre de céramique suivant la revendication 1, 4, 5 ou 8 à 12,
dans laquelle il n'y a que des oxydes secondaires de B et de B' .

14. Poudre de céramique suivant l'une des revendications 1 ou 6 à 13, dans laquelle les oxydes secondaires de B, B' ne forment pas de cristal mixte avec l'une des deux phases pyrochlores.

15. Poudre de céramique suivant l'une des revendications 1 ou 6 à 13, dans laquelle les oxydes secondaires de B, B' ne sont présents que sous la forme d'un cristal mixte.

16. Poudre de céramique suivant l'une des revendications 6 à 13,
dans laquelle les oxydes secondaires de B, B' sont présents sous la forme d'un oxyde et sous la forme d'un cristal mixte.

17. Poudre de céramique suivant la revendication 1,
dans laquelle la poudre de céramique comporte au maximum 10% en poids, notamment au maximum 7% en poids d'un cristal mixte.

18. Poudre de céramique suivant la revendication 1,
dans laquelle la première et la deuxième phases pyrochlores ne forment pas de cristal mixte.

19. Poudre de céramique suivant la revendication 1,
dans laquelle x, y = 2 et z = 7.

20. Couche ( 13 ) de céramique,
préparée à partir d'une poudre de céramique suivant l'une ou plusieurs des revendications précédentes 1 à 19.

21. Couche ( 13 ) de céramique,
préparée exclusivement en une poudre de céramique suivant l'une ou plusieurs des revendications précédentes 1 à 19.

22. Système stratifié,
comportant une couche ( 13 ) de céramique suivant la revendication 20 ou 21.

23. Système stratifié suivant la revendication 22,
dans lequel il y a sous la couche ( 13 ) de céramique une couche ( 10 ) intérieure de céramique,
notamment une couche d'oxyde de zirconium stabilisée, notamment une couche d'oxyde de zirconium stabilisée par de 6% en poids à 8% en poids d'yttrium.

24. Système stratifié suivant la revendication 23,
dans lequel la couche ( 10 ) intérieure a une épaisseur représentant entre 10% et 50% de l'épaisseur (D) totale de la couche ( 10 ) intérieure de céramique et de la couche ( 13 ) extérieure de céramique,
notamment entre 10% et 40% de l'épaisseur totale.

25. Système stratifié suivant la revendication 23 ou 24,
dans lequel l'épaisseur de la couche ( 10 ) intérieure et de la couche ( 13 ) extérieure représente ensemble au moins 300µm, en représentant notamment 300µm.

26. Système stratifié suivant la revendication 23 ou 24,
dans lequel l'épaisseur de la couche ( 10 ) intérieure et de la couche ( 13 ) extérieure représente ensemble au moins 450µm en représentant notamment 450µm.

27. Système stratifié suivant la revendication 23,
dans lequel la couche ( 10 ) intérieure a une épaisseur représentant de 60% jusqu'à 90% de l'épaisseur (D) totale.

28. Système stratifié suivant la revendication 22, 23, 24, 25, 26 ou 27,
dans lequel la couche ( 13 ) de céramique constitue la couche la plus à l'extérieur.

29. Système stratifié suivant la revendication 22 ou 27,
dans lequel le système ( 1 ) stratifié a une couche ( 7 ) métallique d'accrochage,
notamment en un alliage de NiCoCrAlX,
sur le substrat ( 4 ) et sous les couches ( 10, 13 ) de céramique.

30. Système stratifié suivant la revendication 29,
dans lequel la couche ( 7 ) métallique d'accrochage a la composition ( en % en poids )
de 11% à 13% de cobalt,
de 20% à 22% de chrome,
de 10,5% à 11,5% d'aluminium,
de 0,3% à 0,5% d'yttrium,
de 1,5% à 2,5% de rhénium et
le reste étant du nickel,
en en étant notamment constituée.

31. Système stratifié suivant la revendication 29,
dans lequel la couche ( 7 ) métallique d'accrochage a la composition ( en % en poids )
de 24% à 26% de cobalt,
de 16% à 18% de chrome,
de 9,5% à 11% d'aluminium,
de 0,3% à 0,5% d'yttrium,
de 1% à 1,8% de rhénium et
le reste étant du nickel,
en en étant notamment constituée.
